# EUROPEAN PATENT APPLICATION

(11) **EP 4 583 656 A1**
(43) Date of publication of application: **09.07.2025**
(21) Application number: 24217440.7
(22) Date of filing: 04.12.2024
(51) Int. Cl.: H10B 12/00

(54) **SEMICONDUCTOR DEVICE AND METHOD FOR MANUFACTURING THE SAME**

(30) Priority: 03.01.2024 KR 20240001167
(71) Applicant: Samsung Electronics Co., Ltd., Suwon-si, Gyeonggi-do 16677 (KR)
(72) Inventor: HONG, Moonju, Suwon-si, Gyeonggi-do 16677 (KR)
(74) Representative: Kuhnen & Wacker Patent- und Rechtsanwaltsbüro PartG mbB

(57) **Abstract**

An embodiment provides a semiconductor device including: a substrate (100); a bit line (BL) disposed on the substrate (100); an insulating pattern (120) disposed on the bit line (BL); a channel pattern (CP) disposed on the bit line (BL) and extending in a vertical direction (DR3) substantially perpendicular to a surface of the substrate (100) along an upper surface of the bit line (BL) and a sidewall of the insulating pattern (120); a dummy pattern (AG) disposed between the insulating pattern (120) and the channel pattern (CP); a word line (WL1, WL2) that intersects the bit line (BL) and is spaced apart from the channel pattern (CP); a gate insulating pattern (GL) disposed between the channel pattern (CP) and the word line (WL1, WL2); and a landing pad (LP) connected to the channel pattern (CP).

## Description

### BACKGROUND

### 1. Field

The present disclosure relates to a semiconductor device and a method for manufacturing the same.

### 2. Description of the Related Art

Technologies to increase integration of semiconductor devices are required. In the case of two-dimensional semiconductor devices, the degree of integration is mainly determined by the area occupied by a unit memory cell, and the degree of integration in this aspect may depend on the level of fine pattern formation technology.

However, the fine pattern formation technology requires expensive equipment, so although the integration of two-dimensional semiconductor devices is increasing, it is still limited. Accordingly, three-dimensional semiconductor memory devices including three-dimensionally arranged memory cells are being proposed.

### SUMMARY

Embodiments attempt to provide a semiconductor memory device with improved performance and reliability and a method for manufacturing the same.

However, the problems to be solved by embodiments are not limited to the above-described problem and may be variously extended in a range of technical ideas included in embodiments.

An embodiment provides a semiconductor device including: a substrate; a bit line disposed on the substrate; an insulating pattern disposed on the bit line; a channel pattern disposed on the bit line and extending in a vertical direction substantially perpendicular to a surface of the substrate along an upper surface of the bit line and a sidewall of the insulating pattern; a dummy pattern disposed between the insulating pattern and the channel pattern; a word line that intersects the bit line and is spaced apart from the channel pattern; a gate insulating pattern disposed between the channel pattern and the word line; and a landing pad connected to the channel pattern.

Another embodiment provides a method for manufacturing a semiconductor device, including: forming a bit line on a substrate; forming an insulating pattern on the bit line; forming a sacrificial layer on a sidewall of the insulating pattern; forming a channel pattern extending in a vertical direction substantially perpendicular to a surface of the substrate along an upper surface of the bit line and a sidewall of the insulating pattern on the bit line; removing the sacrificial layer to form a dummy pattern disposed between the insulating pattern and the channel pattern; forming a word line that intersects the bit line and is spaced apart from the channel pattern; forming a gate insulating pattern disposed between the channel pattern and the word line; and forming a landing pad connected to the channel pattern.

According to the embodiments, it is possible to provide a semiconductor memory device with improved performance and reliability and a method for manufacturing the same.

It is obvious that the effect of the embodiments is not limited to the above-described effect, and may be variously extended without departing from the scope of the present disclosure.

### BRIEF DESCRIPTION OF THE DRAWINGS

FIG. 1 illustrates a top plan view of a portion of a semiconductor device according to an embodiment.
FIG. 2 illustrates a cross-sectional view taken along line A-A' of FIG. 1.
FIG. 3 illustrates a cross-sectional view taken along line B-B' of FIG. 1.
FIG. 4 to FIG. 16 illustrate cross-sectional views of a method for manufacturing a semiconductor device according to an embodiment.
FIG. 17 illustrates a top plan view of a portion of a semiconductor device according to another embodiment.
FIG. 18 illustrates a cross-sectional view taken along line A-A of FIG. 17.
FIG. 19 illustrates a cross-sectional view taken along line B-B' of FIG. 17.
FIG. 20 to FIG. 30 illustrate cross-sectional views of a method for manufacturing a semiconductor device according to another embodiment.

### DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure.

In order to clearly describe the present disclosure, parts or portions that are irrelevant to the description are omitted, and identical or similar constituent elements throughout the specification are denoted by the same reference numerals.

In addition, the accompanying drawings are provided only in order to allow embodiments disclosed in the present specification to be easily understood and are not to be interpreted as limiting the scope disclosed in the present specification, and it is to be understood that the present disclosure includes all modifications, equivalents, and substitutions without departing from the scope of the present disclosure.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

Furthermore, throughout the specification, "connected" does not only mean when two or more elements are directly connected, but also when two or more elements are indirectly connected through other elements, and when they are physically connected or electrically connected, and further, it may be referred to by different names depending on a position or function, and may also be referred to as a case in which respective parts that are substantially integrated are linked to each other.

When an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise.

It will be understood that, although the terms "first," "second," "third," etc. may be used herein to describe various elements, components, regions, layers and/or sections, these elements, components, regions, layers and/or sections should not be limited by these terms. Unless the context indicates otherwise, these terms are only used to distinguish one element, component, region, layer or section from another element, component, region, layer or section, for example as a naming convention. Thus, a first element, component, region, layer or section discussed below in one section of the specification could be termed a second element, component, region, layer or section in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

Hereinafter, various embodiments and variations will be described in detail with reference to the drawings.

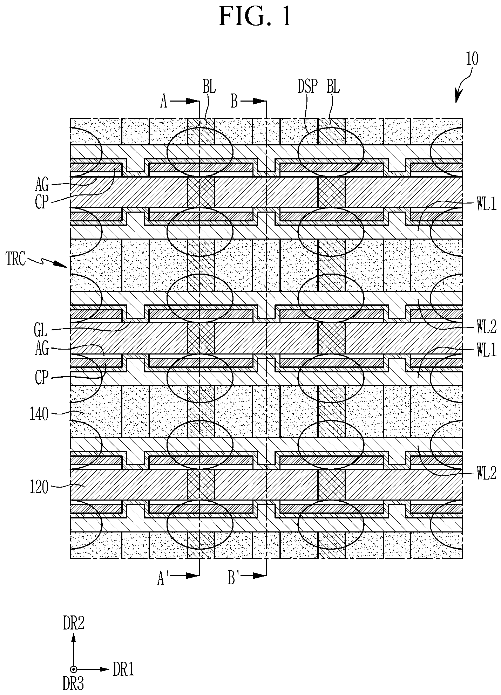

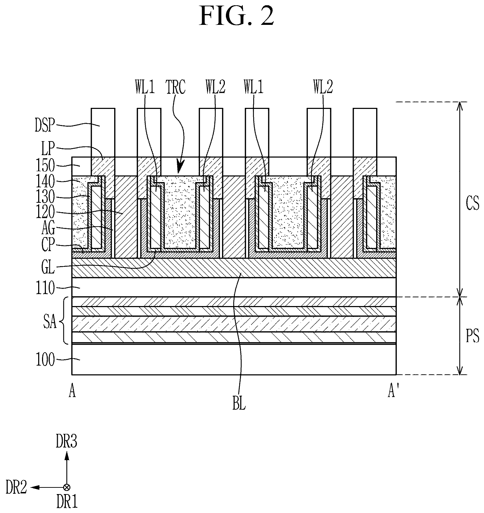

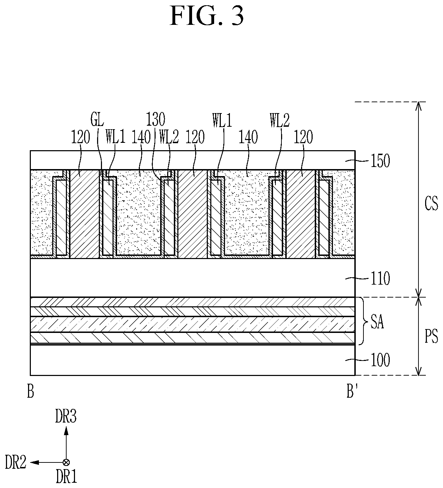

A semiconductor device 10 according to an embodiment will be described with reference to FIG. 1 to FIG. 3. FIG. 1 illustrates a top plan view of a portion of a semiconductor device according to an embodiment, FIG. 2 illustrates a cross-sectional view taken along line A-A' of FIG. 1, and FIG. 3 illustrates a cross-sectional view taken along line B-B' of FIG. 1.

Referring to FIG. 1 to FIG. 3, the semiconductor device 10 according to the embodiment may include a peripheral circuit structure PS and a cell array structure CS disposed on the peripheral circuit structure PS.

The peripheral circuit structure PS may include a substrate 100, and a core and peripheral circuits SA integrated on an upper surface of a substrate 100. The substrate 100 may have a structure in which a base substrate and an epitaxial layer are stacked, but is not limited thereto. For example, in some embodiments, the substrate 100 may be a silicon substrate, a gallium arsenide substrate, a silicon germanium substrate, or a semiconductor on insulator (SOI) substrate. Hereinafter, the substrate 100 will be described as a silicon substrate.

The core and peripheral circuits SA may include NMOS and PMOS transistors integrated on the substrate 100. The core and peripheral circuits SA may be electrically connected to bit lines BL through peripheral circuit wires and peripheral circuit contact plugs. For example, sense amplifiers may be electrically connected to the bit lines BL, and each sense amplifier may amplify and output a difference in voltage levels sensed by a pair of bit lines BL.

The cell array structure CS may include memory cells including a vertical channel transistor (VCT). The vertical channel transistor may refer to a structure in which the channel length extends in a direction perpendicular to the upper surface of the substrate 100.

In the embodiment, the cell array structure CS may include a lower insulating layer 110, bit lines BL, a first insulating pattern 120, channel patterns CP, word lines WL1 and WL2, a gate insulating pattern GL, a second insulating pattern 130, a third insulating pattern 140, landing pads LP, an interlayer insulating layer 150, and data storage patterns DSP.

The lower insulating layer 110 may cover the core and peripheral circuits SA, the peripheral circuit wires, and the peripheral circuit contact plugs on the substrate 100. The lower insulating layer 110 may include insulating films stacked in multiple layers. For example, the lower insulating layer 110 may include a silicon oxide film, a silicon nitride film, a silicon oxynitride film, and/or a low dielectric film.

The bit line BL may be disposed on the substrate 100. For example, the lower insulating layer 110 may be disposed on the substrate 100, and the bit line BL may be disposed on the lower insulating layer 110. For example, the bit line BL may contact an upper surface of the lower insulating layer 110. The lower insulating layer 110 may be disposed to fill a space between the bit lines BL. For example, the lower insulating layer 110 may contact side surfaces of the bit line BL.

In the embodiment, the upper surface of the portion of the lower insulating layer 110 disposed between the bit lines BL may be disposed at the same level as the upper surface of the bit lines BL. For example, upper surfaces of the bit lines BL and the lower insulating layer 110 may be coplanar.

The bit line BL may include a plurality of bit lines BL, and the plurality of bit lines BL may be spaced apart from each other in the first direction DR1 and may extend lengthwise in the second direction DR2.

The bit line BL may include doped polysilicon, metal, a conductive metal nitride, a conductive metal silicide, a conductive metal oxide, or a combination thereof. For example, the bit lines BL may include Al, Cu, Ti, Ta, Ru, W, Mo, Pt, Ni, Co, TiN, TaN, WN, NbN, TiAl, TiAIN, TiSi, TiSiN, TaSi, TaSiN, RuTiN, NiSi, CoSi, IrOx, RuOx, or a combination thereof, but is not limited thereto. The bit line BL may include a single layer or a multilayer including the materials described above.

In the embodiment, the bit line BL may include a two-dimensional semiconductor material, and for example, the two-dimensional semiconductor material may include graphene, carbon nanotube, or a combination thereof.

The first insulating patterns 120 may be disposed on the lower insulating layer 110. In the embodiment, the first insulating patterns 120 may be disposed on the upper surface of the bit line BL. For example, the first insulating patterns 120 may contact upper surfaces of the lower insulating layer 110 and the bit lines BL. The first insulating patterns 120 may extend across the bit line BL along the first direction DR1, and may be spaced apart from each other in the second direction DR2.

The first insulating patterns 120 may form channel trenches TRC that extends along the first direction DR1 across the bit lines BL and are spaced apart from each other along the second direction DR2.

The first insulating patterns 120 may include, for example, at least one of a silicon oxide, a silicon oxynitride, a silicon nitride, and a low-k material having a dielectric constant smaller than that of the silicon oxide, but is not limited thereto.

The low-k material may include, for example, at least one of polymeric materials of a flowable oxide (FOX), a torene silazene (TOSZ), an undoped silicate glass (USG), a borosilicate glass (BSG), a phosphosilicate glass (PSG), a borophosphosilicate glass (BPSG), a plasma enhanced tetra ethyl ortho silicate (PETEOS), a fluoride silicate glass (FSG), a carbon doped silicon oxide (CDO), xerogel, aerogel, an amorphous fluorinated carbon, an organo silicate glass (OSG), parylene, a bis-benzocyclobutenes (BCB), SiLK, polyimide, a porous polymeric material, and a combination thereof, but is not limited thereto.

According to the embodiment, the first insulating patterns 120 may include one layer, but the embodiment is not limited thereto, and according to another embodiment, the first insulating patterns 120 may include one or more layers.

The channel patterns CP may be disposed on bit lines BL. The channel patterns CP may contact upper surfaces of the bit lines BL. The channel patterns CP may be spaced apart from each other in the second direction DR2 on each bit line BL. That is, the channel patterns CP may be spaced apart from each other in the first direction DR1 and the second direction DR2 crossing each other and disposed in a matrix form.

The channel pattern CP may include a first source/drain area and a second source/drain area. For example, the lower portion of the channel pattern CP may be connected to the bit line BL to function as the first source/drain area, the upper portion of the channel pattern CP may be connected to a landing pad LP to function as the second source/drain region, and a portion of the channel pattern CP between the first source/drain area and the second source/drain area may function as a channel area.

Specifically, the channel patterns CP may be spaced apart from each other along the second direction DR2 in each of the channel trenches TRC. The first insulating pattern 120 may be disposed between the channel patterns CP adjacent to each other in the second direction DR2. The channel patterns CP may be disposed between the first insulating patterns 120 that are spaced apart from each other in the second direction DR2. The channel patterns CP may extend along the profile of the channel trench TRC. Accordingly, in a cross-sectional view, the channel patterns CP may have an approximately "U" shape with two vertically extending legs extending along a third direction DR3 perpendicular to the first direction DR1 and the second direction DR2.

The channel patterns CP may include an indium gallium zinc oxide (IGZO), an indium gallium silicon oxide (IGSO), an indium tin zinc oxide (ITZO), an indium zinc oxide (IZO), a zinc oxide (ZnO), a zinc tin oxide (ZTO), a zinc oxynitride (ZnON), a zirconium zinc tin oxide (ZZTO), a tin oxide (SnO), a hafnium indium zinc oxide (HIZO), a gallium zinc tin oxide (GZTO), an aluminum zinc tin oxide (AZTO), a ytterbium gallium zinc oxide (YGZO), an indium gallium oxide (IGO), or a combination thereof. However, the embodiment is not limited thereto.

A dummy pattern AG may be disposed between the first insulating pattern 120 and the channel pattern CP.

The dummy pattern AG may be empty inside (i.e. the dummy pattern may comprise or be a cavity) so that air may be filled in the dummy pattern AG, oxygen (O₂) contained in the air may be diffused into the channel pattern CP, and oxygen may be injected into the channel pattern CP without the process of stacking and annealing an additional oxide layer. The term "air" as discussed herein, may refer to atmospheric air, or other gases that may be present during the manufacturing process.

The dummy pattern AG may be disposed along a sidewall of the first insulating pattern 120, and along the third direction DR3 perpendicular to the first direction DR1 and the second direction DR2. A height of the dummy pattern AG may be substantially the same as a height in the third direction DR3 of the channel pattern CP and may be lower than a height in the third direction DR3 of the first insulating pattern 120. In embodiments, the dummy pattern AG may be a plurality of dummy patterns AG spaced apart from each other along the first direction DR1.

According to the embodiment, the dummy pattern AG may not be disposed in an area in which the channel pattern CP is not disposed.

The word lines WL1 and WL2 may extend across the bit lines BL along the first direction DR1, and may be spaced apart from each other in the second direction DR2. The word lines WL1 and WL2 may be spaced apart from the bit line BL in the third direction DR3, and may cross the bit line BL. A pair of word lines WL1 and WL2 may be disposed between the two legs of the channel patterns CP in the channel trench TRC.

Specifically, each of the word lines WL1 and WL2 includes a first surface and a second surface opposite to the first surface along the second direction DR2, and the first surfaces of two adjacent word lines WL1 and WL2 may be disposed to face each other between the two legs of the channel patterns CP.

The first surfaces of the word lines WL1 and WL2 may face the second insulating pattern 130 to be described later, the second surfaces thereof may face the channel pattern CP, and the gate insulating pattern GL may be disposed between the word lines WL1 and WL2 and the channel pattern CP. For example, the gate insulating pattern GL may contact the word lines WL1 and WL2 and the channel patterns CP.

Each of the word lines WL1 and WL2 may include an upper surface and a lower surface facing along the third direction DR3. The upper surfaces of the word lines WL1 and WL2 may face the second insulating pattern 130 to be described later, and, at least a portion of the landing pad LP is disposed on the second insulating pattern 130, and at least a portion of the landing pad LP is disposed on the second insulating pattern 130, so that a portion of the landing pad LP disposed on the second insulating pattern 130 may face the upper surfaces of the word lines WL1 and WL2 with the second insulating pattern 130 interposed therebetween in the third direction DR3.

The lower surfaces of the word lines WL1 and WL2 may face the gate insulating pattern GL to be described later along the third direction DR3, and may face the bit line BL with the gate insulating pattern GL and the channel pattern CP interposed therebetween in the third direction DR3.

In the embodiment, the upper surfaces of the word lines WL1 and WL2 are shown to be disposed at a higher level in the third direction DR3 than the upper surfaces of the channel patterns CP, but the embodiment is not limited thereto, and according to another embodiment, the upper surfaces of the word lines WL1 and WL2 may be disposed at the same level as or at a lower level than the upper surfaces of the channel patterns CP.

The word lines WL1 and WL2 may be formed of or include, for example, doped polysilicon, metal, a conductive metal nitride, a conductive metal silicide, a conductive metal oxide, or a combination thereof. For example, the word lines WL1 and WL2 may be formed of or include Al, Cu, Ti, Ta, Ru, W, Mo, Pt, Ni, Co, TiN, TaN, WN, NbN, TiAl, TiAIN, TiSi, TiSiN, TaSi, TaSiN, RuTiN, NiSi, CoSi, IrOx, RuOx, or a combination thereof, but is not limited thereto.

The word lines WL1 and WL2 may include a single layer or a multilayer of the materials described above. In another embodiment, the word lines WL1 and WL2 may include a two-dimensional semiconductor material, and for example, the two-dimensional semiconductor material may be formed of or include graphene, carbon nanotube, or a combination thereof.

The gate insulating pattern GL may extend in the third direction DR3 along the word lines WL1 and WL2. The gate insulating pattern GL may not be disposed on a portion of the channel pattern CP that does not overlap the word lines WL1 and WL2 along the third direction DR3.

In a cross-sectional view parallel to the second direction DR2, the gate insulating pattern GL may extend along the side and lower surfaces of the word lines WL1 and WL2 adjacent to the channel pattern CP.

In addition, a portion of the gate insulating pattern GL may protrude in the third direction DR3 from the upper surfaces of the word lines WL1 and WL2, and may contact the landing pad LP. For example, an upper surface of the gate insulating pattern GL may be at a higher vertical level than upper surfaces of the word lines WL1 and WL2.

The gate insulating pattern GL may be formed of a silicon oxide film, a silicon oxynitride film, a high dielectric film having a dielectric constant higher than that of the silicon oxide film, or a combination thereof. The high dielectric film may be formed of or include a metal oxide or a metal oxynitride. For example, the high dielectric film usable as the gate insulating pattern GL may be formed of or include one of HfO₂, HfSiO, HfSiON, HfTaO, HfTiO, HfZrO, ZrO₂, Al₂O₃, or a combination thereof, but is not limited thereto, and the materials included in the gate insulating pattern GL may be variously changed.

The second insulating pattern 130 may be disposed on the channel pattern CP and the lower insulating layer 110, and the second insulating pattern 130 may be disposed in the channel trench TRC. The second insulating pattern 130 may be disposed on the channel pattern CP and the word lines WL1 and WL2.

The second insulating pattern 130 may be disposed on a portion of the channel pattern CP that does not overlap the word lines WL1 and WL2 along the third direction DR3 to be in contact with the channel pattern CP.

The second insulating pattern 130 may extend along the side surfaces of the word lines WL1 and WL2 and along the upper surfaces of the word lines WL1 and WL2, and may be in contact with the side and upper surfaces of the word lines WL1 and WL2.

Similar to the gate insulating pattern GL, along the third direction DR3, a portion of the second insulating pattern 130 may protrude from the upper surfaces of the word lines WL1 and WL2, and may contact a portion of the protruding gate insulating pattern GL. For example, an upper surface of the second insulating pattern 130 may be at a higher vertical level than upper surfaces of the word lines WL1 and WL2. The upper surface of the second insulating pattern 130 may be coplanar with the upper surface of the gate insulating pattern GL.

In the embodiment, the second insulating pattern 130 may include the same material as the gate insulating pattern GL described above. However, the embodiment is not limited thereto, and in another embodiment, the second insulating pattern 130 may include an insulating material different from the gate insulating pattern GL.

The third insulating pattern 140 may be disposed in the channel trench TRC. The third insulating pattern 140 may fill the channel trench TRC remaining after the channel pattern CP, the gate insulating pattern GL, the word lines WL1 and WL2, and the second insulating pattern 130 are formed. The third insulating pattern 140 may contact the second insulating pattern 130. An upper surface of the third insulating pattern 140 may be coplanar with upper surfaces of the second insulating pattern 130 and the gate insulating pattern GL.

The third insulating pattern 140 may include a horizontal portion and a vertical portion. The horizontal portion may be disposed on the vertical portion of the third insulating pattern 140 along the third direction DR3. The horizontal portion of the third insulating pattern 140 may be wider than the vertical portion of the third insulating pattern 140. Side surfaces of the horizontal portion of the third insulating pattern 140 may be perpendicular to an upper surface of the substrate 100.

The horizontal portion of the third insulating pattern 140 may be disposed on the upper surfaces of the word lines WL1 and WL2, and the vertical portion of the third insulating pattern 140 may be disposed on the bit line BL. The vertical portion of the third insulating pattern 140 may be closer to the bit line BL than the horizontal portion of the third insulating pattern 140. The vertical portion of the third insulating pattern 140 may extend in the third direction DR3 from the horizontal portion of the third insulating pattern 140 toward the bit line BL. Accordingly, in a cross-sectional view, the third insulating pattern 140 may have an approximately "T" shape. However, the embodiment is not limited thereto, and the shape of the third insulating pattern 140 may be variously modified in a cross-sectional view.

The third insulating pattern 140 may be formed of or include, for example, at least one of a silicon oxide, a silicon oxynitride, a silicon nitride, and a low-k material having a dielectric constant smaller than that of the silicon oxide, but the embodiment is not limited thereto.

Each of the landing pads LP may overlap at least a portion of the channel pattern CP along the third direction DR3. The landing pads LP may be spaced apart from each other in the first direction DR1 and the second direction DR2 and may be disposed in a matrix form. However, this is only an example, and it goes without saying that the plurality of landing pads LP may be disposed in various other forms, such as a honeycomb shape, as long as they are connected to the channel pattern CP.

On a plane formed by the intersection of the first direction DR1 and the second direction DR2, the landing pads LP may have various shapes such as circular, elliptical, rectangular, square, rhombic, and hexagonal shapes. However, the embodiment is not limited thereto, and the planar shape of the landing pad LP may vary.

The landing pads LP may be disposed on the first insulating pattern 120 and the third insulating pattern 140. The landing pads LP may be connected to the channel pattern CP. The landing pads LP may penetrate the interlayer insulating layer 150 to be in contact with the upper portion of the channel pattern CP.

The landing pads LP may include a first portion disposed on the upper surface of the gate insulating pattern GL, the upper surface of the second insulating pattern 130, and the upper surface of the third insulating pattern 140 and a second portion extending from the first portion to be in contact with the upper surface of the channel pattern CP. The first portion of the landing pads LP may contact upper surfaces of the second insulating pattern 130, the third insulating pattern 140, and the gate insulating pattern GL.

The first portion of the landing pads LP may extend in the second direction DR2. For example, the first portion of the landing pads LP may be wider than the second portion of the landing pads LP.

The lower surface of the first portion of the landing pad LP may be disposed at the same level as the upper surface of the first insulating pattern 120 and the upper surface of the third insulating pattern 140, but the embodiment is not limited thereto. In another embodiment, the lower surface of the first portion of the landing pad LP may be disposed at a lower level than the upper surface of the first insulating pattern 120 and the upper surface of the third insulating pattern 140.

The second portion of the landing pad LP may extend from the first portion thereof in the third direction DR3 and may be in contact with the upper surface of the channel pattern CP. The second portion of the landing pad LP may contact an upper surface of the dummy pattern AG.

One side of the second portion of the landing pad LP may contact the first insulating pattern 120, and the other side of the second portion of the landing pad LP may contact the gate insulating pattern GL. The lower surface of the second portion of the landing pad LP may be disposed at a level lower than the upper surfaces of the word lines WL1 and WL2. However, the embodiment is not limited thereto. For example, in another embodiment, the lower surface of the second portion LP2 of the landing pad LP may be disposed at substantially the same level as the upper surfaces of the word lines WL1 and WL2.

The landing pad LP may be electrically connected to the channel pattern CP. For example, a lower surface of the landing pad LP may contact an upper surface of the channel pattern CP. However, the embodiment is not limited thereto, and as long as the landing pads LP are connected to the channel pattern CP, the disposition of the landing pads LP may be variously changed.

The landing pads LP may be formed of or include doped polysilicon, metal, a conductive metal nitride, a conductive metal silicide, a conductive metal oxide, or a combination thereof. For example, the landing pads LP may be formed of or include one of Al, Cu, Ti, Ta, Ru, W, Mo, Pt, Ni, Co, TiN, TaN, WN, NbN, TiAl, TiAIN, TiSi, TiSiN, TaSi, TaSiN, RuTiN, NiSi, CoSi, IrOx, RuOx, or a combination thereof, but the embodiment is not limited thereto.

The interlayer insulating layer 150 may fill a space between the landing pads LPs spaced apart from each other in the second direction DR2 on the first insulating pattern 120 and the third insulating pattern 140. The interlayer insulating layer 150 may contact upper surfaces of the first insulating pattern 120 and the third insulating pattern 140. For example, the lower surface of the interlayer insulating layer 150 may be disposed at the same level as the lower surface of the first portion of the landing pads LP. However, it is not limited thereto, and in some embodiments, the lower surface of the interlayer insulating layer 150 may be disposed at a different level from the lower surface of the first portion of the landing pads LP.

The data storage patterns DSP may be disposed on the landing pads LP, respectively. For example, each data storage pattern DSP may contact an upper surface of a corresponding one of the landing pads LP. The data storage patterns DSP may be electrically connected to the channel pattern CP through the landing pads LP, respectively. As shown in FIG. 1, the data storage patterns DSP may be disposed in a matrix form along the first direction DR1 and the second direction DR2.

In the embodiment, the data storage patterns DSP may be capacitors, and may include lower and upper electrodes and capacitor dielectric films interposed therebetween. When the data storage patterns DSP have the above structure, the lower electrode may contact the landing pad LP, and the lower electrode may have various shapes such as circular, elliptical, rectangular, square, rhombic, and hexagonal shapes in a plan view.

Alternatively, the data storage patterns DSP may be variable resistance patterns that may be switched into two resistance states by an electrical pulse applied to a memory element. For example, the data storage patterns DSP may include phase-change materials whose crystal states change depending on an amount of current, perovskite compounds, transition metal oxides, magnetic materials, ferromagnetic materials, or antiferromagnetic materials.

According to the semiconductor device 10 according to the embodiment, the dummy pattern AG disposed between the first insulating pattern 120 and the channel pattern CP and disposed on the sidewall of the first insulating pattern 120 is included, and the dummy pattern AG may be empty (i.e. the dummy pattern may comprise or be a cavity) so that air may be filled in the dummy pattern AG, and oxygen (O₂) contained in the air in the dummy pattern AG may diffuse into the channel pattern CP. Accordingly, oxygen may be injected into the channel pattern CP without a process of stacking and annealing an additional oxide layer.

As such, it is possible to increase the carrier concentration in the channel pattern CP without a process of stacking and annealing an additional oxide layer, thereby reducing manufacturing costs, preventing metal oxidation due to the annealing process, and providing a semiconductor device with excellent performance and operating characteristics and improved electrical characteristics.

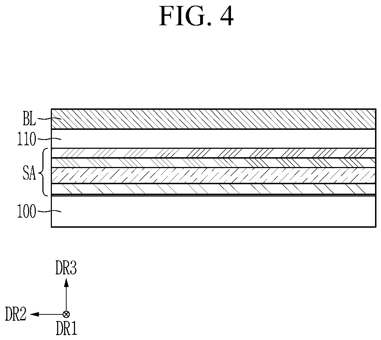

A method for manufacturing the semiconductor device 10 according to the embodiment will be described with reference to FIG. 4 to FIG. 17 together with FIG. 1 to FIG. 3. FIG. 4 to FIG. 16 illustrate cross-sectional views of a method for manufacturing a semiconductor device according to an embodiment. FIG. 4 to FIG. 16 illustrate cross-sectional views taken along line A-A of FIG. 1.

Referring to FIG. 4, the core and peripheral circuits SA, peripheral circuit wires and peripheral circuit contact plugs electrically connected to the core and peripheral circuits SA are formed on the substrate 100, the lower insulating layer 110 is formed thereon, the bit line BL is formed on the lower insulating layer 110, and the insulating material may be filled between the bit lines BL.

The core and peripheral circuits SA may include at least one NMOS transistor and/or at least one PMOS transistor.

The lower insulating layer 110 may be formed of or include a silicon oxide film, a silicon nitride film, a silicon oxynitride film, and/or a low dielectric film.

The bit lines BL may be formed by depositing a conductive layer on the lower insulating layer 110 and then patterning the conductive layer.

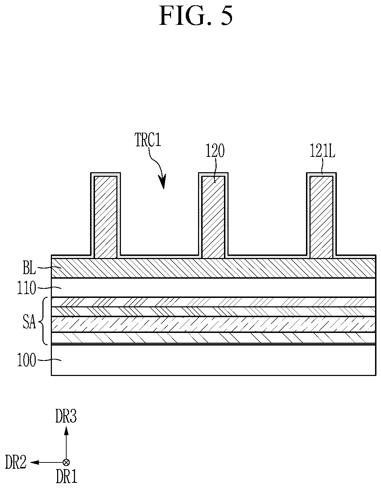

Referring to FIG. 5, the first insulating pattern 120 extending in the first direction DR1 and defining first trenches TRC1 spaced apart from each other in the second direction DR2 may be formed on the bit lines BL and the lower insulating layer 110, and a sacrificial layer 121L may be conformally deposited on the upper surface and the side surface of the first insulating pattern 120 and the upper surface of the bit line BL.

The first trenches TRC1 may be formed across the bit lines BL. The first insulating pattern 120 may be formed of, for example, a silicon oxide film, a silicon nitride film, a silicon oxynitride film, and/or a low dielectric film.

The sacrificial layer 121L may include a material having wet etching conditions different from those of the first insulating pattern 120, the gate insulating pattern GL, and the channel pattern CP. For example, the sacrificial layer 121L may be formed of or include a metal, for example, the sacrificial layer 121L may be formed of or include titanium nitride (TiN), but the embodiment is not limited thereto.

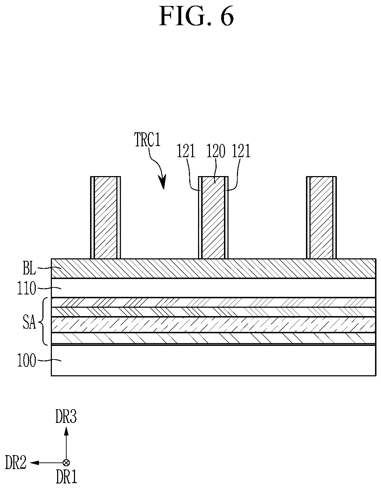

Referring to FIG. 6, the sacrificial layer 121L may be etched to remove the sacrificial layer 121L disposed on the upper surface of the first insulating pattern 120 and the upper surface of the bit line BL to form a sacrificial pattern 121 disposed on the side surface of the first insulating pattern 120. For example, the sacrificial layer 121L disposed on the upper surface of the first insulating pattern 120 and the upper surface of the bit line BL may be removed through an anisotropic etching process, but the embodiment is not limited thereto.

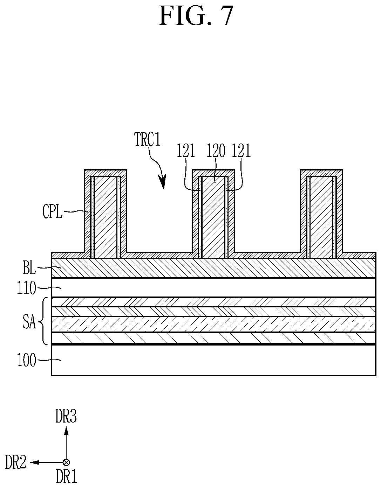

Referring to FIG. 7, a channel pattern material layer CPL may be conformally deposited on the upper surfaces of the first insulating pattern 120 and the sacrificial pattern 121, the side surface of the sacrificial pattern 121, and the upper surface of the bit line BL.

The channel pattern material layer CPL may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD). However, the embodiment is not limited thereto, and a method of depositing the channel pattern material layer CPL may be variously changed.

The channel pattern material layer CPL may be formed of or include a semiconductor material, an oxide semiconductor material, or a two-dimensional semiconductor material. The channel pattern material layer CPL may be formed of or include, for example, silicon, germanium, silicon-germanium, or an indium gallium zinc oxide (IGZO).

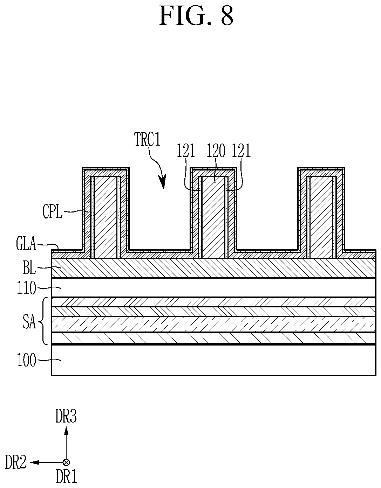

As shown in FIG. 8, a first gate insulating layer GLA may be stacked on the channel pattern material layer CPL, and by patterning the first gate insulating layer GLA and the channel pattern material layer CPL, the first gate insulating layer GLA and the channel pattern material layer CPL may be left only in the area in which the channel pattern CP is disposed in a plan view. In this case, the first gate insulating layer GLA and the channel pattern material layer CPL disposed in the area in which the channel pattern CP is not disposed may be removed.

The first gate insulating layer GLA may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD). However, the embodiment is not limited thereto.

The first gate insulating layer GLA may be formed of a silicon oxide film, a silicon oxynitride film, a high dielectric film having a dielectric constant higher than that of the silicon oxide film, or a combination thereof. The high dielectric film may be formed of or include a metal oxide or a metal oxynitride. For example, the high dielectric film usable as the gate insulating pattern GL may be formed of or include one of HfO₂, HfSiO, HfSiON, HfTaO, HfTiO,HfZrO, ZrO₂, and Al₂O₃, or a combination thereof, but is not limited thereto, and the materials included in the first gate insulating layer GLA may be variously changed.

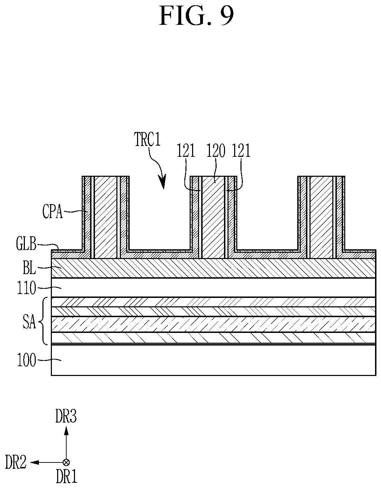

Referring to FIG. 9, the first gate insulating layer GLA and the channel pattern material layer CPL disposed on the upper surface of the first insulating pattern 120 may be removed to form a preliminary channel pattern CPA disposed on the side surface of the first insulating pattern 120 and the upper surface of the bit line BL in the first trench TRC1, a first preliminary gate insulating pattern GLB disposed on the preliminary channel pattern CPA may be formed, the sacrificial pattern 121 between the first insulating pattern 120 and the preliminary channel pattern CPA may be exposed, and the upper surface of the first insulating pattern 120 may be exposed.

In this case, after the sacrificial layer is formed to fill the first trench TRC1, the first gate insulating layer GLA and the channel pattern material layer CPL disposed on the upper surface of the first insulating pattern 120 exposed without being covered by the sacrificial layer may be patterned to form the preliminary channel pattern CPA, form the first preliminary gate insulating pattern GLB, expose the sacrificial pattern 121, and expose the upper surface of the first insulating pattern 120.

However, the embodiment is not limited thereto. For example, after the sacrificial layer is formed to fill the first trench TRC1, a planarization process of exposing the upper surface of the first insulating pattern 120 may be performed to form the preliminary channel pattern CPA, form the first preliminary gate insulating pattern GLB, expose the sacrificial pattern 121, and expose the upper surface of the first insulating pattern 120.

The preliminary channel pattern CPA is formed along the profile of the first trench TRC1, and the upper surface of the preliminary channel pattern CPA may be disposed at substantially the same level as the upper surface of the first insulating pattern 120.

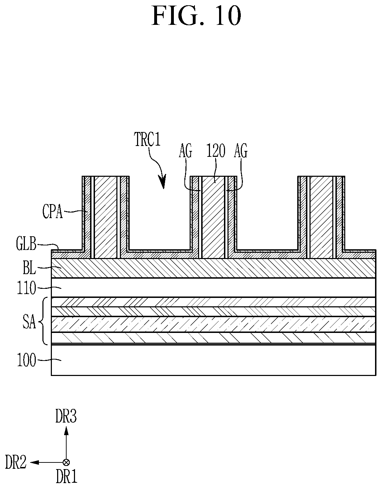

As shown in FIG. 10, the sacrificial pattern 121 disposed between the first insulating pattern 120 and the preliminary channel pattern CPA may be removed to form the dummy pattern AG filled with air.

The sacrificial pattern 121 may be removed by a wet etching process, but the embodiment is not limited thereto.

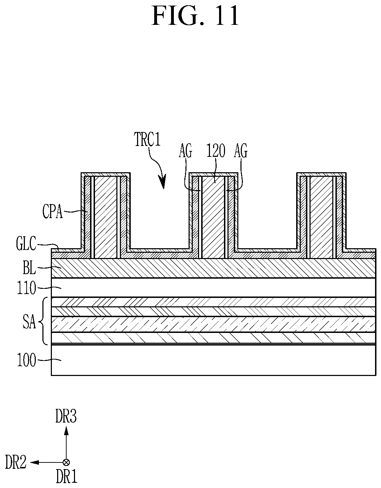

Referring to FIG. 11, a gate insulating pattern material may be conformally further deposited on the upper surface of the first insulating pattern 120, the upper surface of the preliminary channel pattern CPA, the upper surface of the dummy pattern AG, and the first preliminary gate insulating pattern GLB to form a second preliminary gate insulating pattern GLC.

The second preliminary gate insulating pattern GLC may also be formed in an area of the first trench TRC1 in which the channel pattern CP will not be formed.

The second preliminary gate insulating pattern GLC may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD). However, the embodiment is not limited thereto.

The second preliminary gate insulating pattern GLC may be formed of a silicon oxide film, a silicon oxynitride film, a high dielectric film having a dielectric constant higher than that of the silicon oxide film, or a combination thereof. The high dielectric film may be formed of or include a metal oxide or a metal oxynitride. For example, the high dielectric film usable as the gate insulating pattern GL may be made of HfO₂, HfSiO, HfSiON, HfTaO, HfTiO, HfZrO, ZrO₂, Al₂O₃, or a combination thereof, but is not limited thereto, and the materials included in the second preliminary gate insulating pattern GLC may be variously changed.

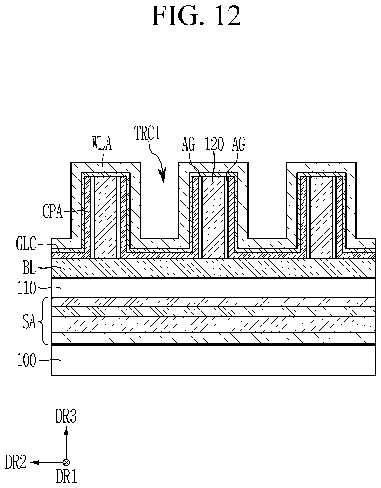

As shown in FIG. 12, a word line material layer WLA may be deposited to conformally cover the second preliminary gate insulating pattern GLC.

The word line material layer WLA may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD). However, the embodiment is not limited thereto.

The word line material layer WLA may be formed of or include doped polysilicon, metal, a conductive metal nitride, a conductive metal silicide, a conductive metal oxide, or a combination thereof.

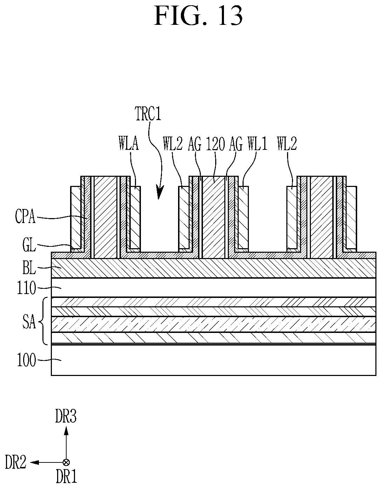

Referring to FIG. 13, the second preliminary gate insulating pattern GLC and the word line material layer WLA may be etched to form the gate insulating pattern GL and the word lines WL1 and WL2 in the first trench TRC1.

By performing an anisotropic etching process on the word line material layer WLA, a pair of word lines WL1 and WL2 that are separated to be spaced apart from each other along the second direction DR2 may be formed in the first trench TRC1. In addition, the gate insulating patterns GL that are separated to be spaced apart from each other along the second direction DR2 may be formed in the first trench TRC1.

During the anisotropic etching process for the word line material layer WLA, the upper surfaces of the word lines WL1 and WL2 may be lower than an upper surface of a second channel pattern CP2. Alternatively, in another embodiment, an etching process of recessing the upper surfaces of the word lines WL1 and WL2 may be additionally performed.

In the embodiment, an etching process of cutting the second preliminary gate insulating pattern GLC may be performed simultaneously with an etching process of cutting the word line material layer WLA. In this case, one end of each gate insulating pattern GL may be continuous with the side surfaces of the corresponding word lines WL1 and WL2.

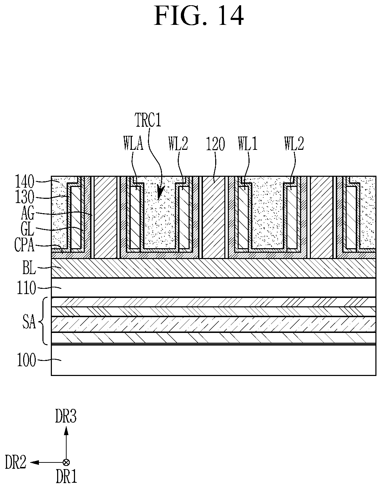

Referring to FIG. 14, the second insulating pattern 130 and the third insulating pattern 140 may be formed on the gate insulating pattern GL and the word lines WL1 and WL2. The third insulating pattern 140 may fill the first trench TRC1.

Specifically, the second insulating pattern 130 may be conformally formed along profiles of the gate insulating pattern GL, the word lines WL1 and WL2, and the preliminary channel pattern CPA in the first trench TRC1.

The second insulating pattern 130 may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD). However, the embodiment is not limited thereto, and a method of depositing the second insulating pattern 130 may be variously changed.

Next, the third insulating pattern 140 may be formed to fill the first trench TRC1 remaining after the second insulating pattern 130 is formed.

The process of forming the second insulating pattern 130 and the third insulating pattern 140 may include a planarization process of exposing the upper surface of the first insulating pattern 120, the upper surface of the preliminary channel pattern CPA, and the upper surface of the gate insulating pattern GL. For example, the second insulating pattern 130 and the third insulating pattern 140 may be portions of the second insulating pattern 130 and the third insulating pattern 140 remaining in the first trench TRC1 while the planarization process is performed. The second insulating pattern 130 and the third insulating pattern 140 disposed at a level higher than the upper surface of the first insulating pattern 120, the upper surface of the preliminary channel pattern CPA, and the upper surface of the gate insulating pattern GL may be removed by the planarization process.

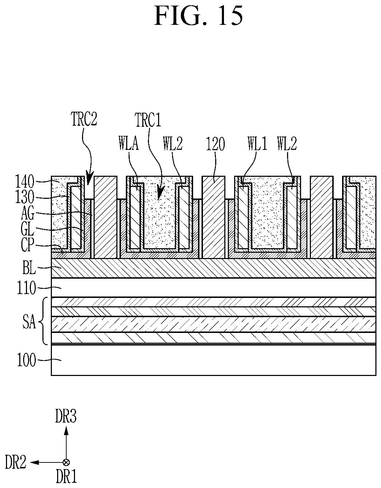

Referring to FIG. 15, the channel pattern CP and a second trench TRC2 may be formed through an etching process of recessing a portion of the preliminary channel pattern CPA.

Specifically, the preliminary channel pattern CPA may be partially wet-etched from the upper surface thereof toward the lower surface thereof to form the channel pattern CP and form the second trench TRC2 extending in the third direction DR3. Accordingly, the upper surface of the channel pattern CP may be disposed at a lower level than the upper surfaces of the word lines WL1 and WL2.

In the embodiment, a portion of the channel pattern CP may be wet-etched using an etchant selectively etching the channel pattern CP. However, the embodiment is not limited thereto, and an etching process for recessing the channel pattern CP may be variously changed.

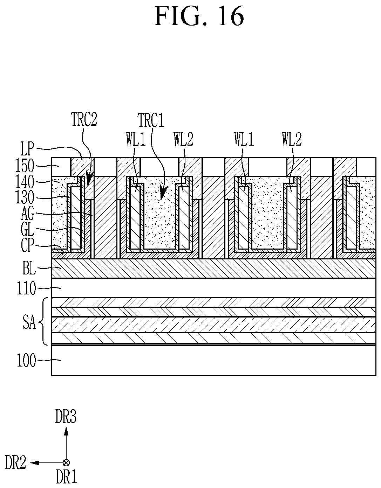

Referring to FIG. 16, the landing pads LP filling the second trench TRC2 and connected to the channel pattern CP may be formed and the interlayer insulating layer 150 filling a space between the landing pads LP may be formed.

Specifically, after patterning the landing pads LP to form holes exposing the upper surfaces of the first and third insulating patterns 120 and 140, the interlayer insulating layer 150 may be embedded in the holes, and then a planarization process may be performed. For example, the interlayer insulating layer 150 may fill the holes between the landing pads LP. However, the embodiment is not limited thereto. The order of forming the landing pads LP and the interlayer insulating layer 150 is not limited thereto, and in another embodiment, after forming and patterning the interlayer insulating layer 150, the landing pads LP penetrating the interlayer insulating layer 150 may be formed.

The data storage patterns DSP may be formed on the landing pads LP, respectively, to form the semiconductor device 10 according to an embodiment. In the embodiment, when the data storage patterns DSP include capacitors, lower electrodes, capacitor dielectric layers, and upper electrodes may be sequentially formed.

According to the method for manufacturing the semiconductor device according to the present embodiment, by forming the sacrificial layer on the sidewall of the first insulating pattern 120, forming the channel pattern, and then removing the sacrificial layer to form the dummy pattern filled with air in the area of the sacrificial layer, oxygen contained in the dummy pattern may be diffused into the channel pattern without an additional annealing process. Accordingly, the manufacturing method is simplified, which may reduce the manufacturing cost, metal oxidation due to the annealing process may not occur, and a semiconductor device with excellent performance and operation characteristics and improved electrical characteristics may be provided.

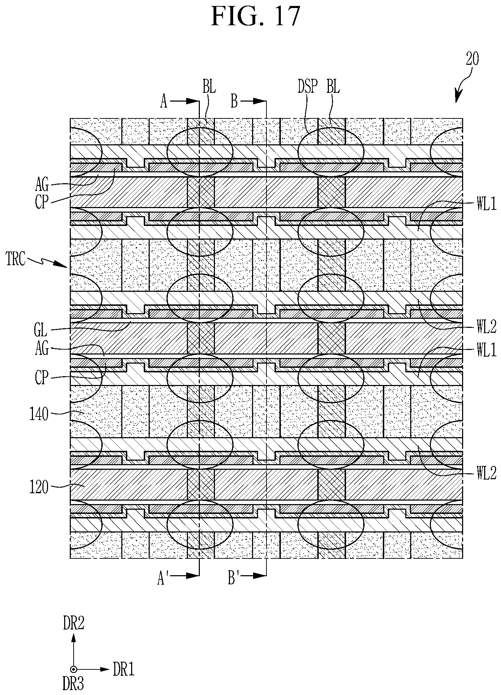

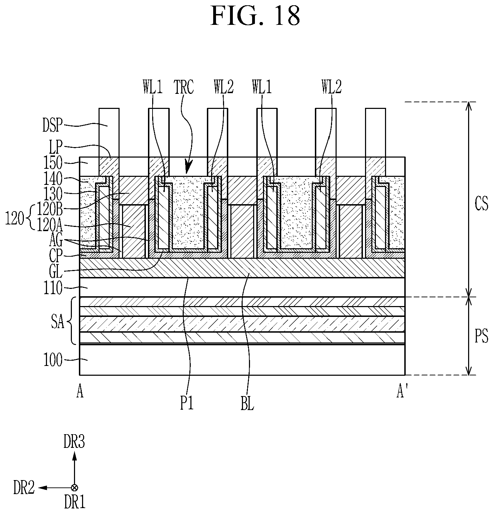

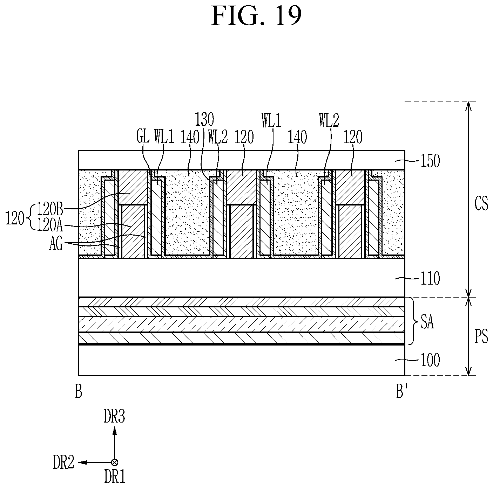

A semiconductor device 20 according to another embodiment will be described with reference to FIG. 17 to FIG. 19. FIG. 17 illustrates a top plan view of a portion of a semiconductor device according to another embodiment, FIG. 18 illustrates a cross-sectional view taken along line A-A' of FIG. 17, and FIG. 19 illustrates a cross-sectional view taken along line B-B' of FIG. 17.

Referring to FIG. 17 to FIG. 19, the semiconductor device according to the present embodiment is similar to the semiconductor device according to the embodiment described above with reference to FIG. 1 to FIG. 3. The same configuration is referred to by the same reference number, redundant descriptions are omitted or simplified, and differences are mainly described.

Referring to FIG. 17 to FIG. 19, the semiconductor device 20 according to the present embodiment may include a peripheral circuit structure PS and a cell array structure CS disposed on the peripheral circuit structure PS.

The peripheral circuit structure PS may include a substrate 100, and a core and peripheral circuits SA integrated on an upper surface of a substrate 100.

The cell array structure CS may include a lower insulating layer 110, a bit line BL, a first insulating pattern 120, channel patterns CP, word lines WL1 and WL2, a gate insulating pattern GL, a second insulating pattern 130, a third insulating pattern 140, landing pads LP, an interlayer insulating layer 150, and data storage patterns DSP.

The lower insulating layer 110 may be disposed on the substrate 100, and the lower insulating layer 110 may cover the core and peripheral circuits SA on the substrate 100.

The bit lines BL may be disposed on the lower insulating layer 110. The bit line BL may include a plurality of bit lines BL, and the plurality of bit lines BL may be spaced apart from each other in the first direction DR1 and may extend lengthwise in the second direction DR2.

The lower insulating layer 110 may be disposed to fill a space between the bit lines BL. For example, the lower insulating layer 110 may contact lower and side surfaces of the bit line BL.

The first insulating pattern 120 may be disposed on the lower insulating layer 110. The first insulating pattern 120 may extend across the bit line BL along the first direction DR1, and may be spaced apart from each other in the second direction DR2.

The first insulating pattern 120 may form channel trenches TRC that extend along the first direction DR1 across the bit lines BL and are spaced apart from each other along the second direction DR2.

According to the semiconductor device 20 according to the present embodiment, the first insulating pattern 120 may include a first sub-insulating pattern 120A and a second sub-insulating pattern 120B disposed on the first sub-insulating pattern 120A. The first sub-insulating pattern 120A may contact upper surfaces of the bit lines BL and the lower insulating layer 110, and the second sub-insulating pattern 120B may contact an upper surface of the first sub-insulating pattern 120A.

A width of the second sub-insulating pattern 120B of the first insulating pattern 120 may be wider than a width of the first sub-insulating pattern 120A thereof. Side surfaces of the second sub-insulating pattern 120B and side surfaces of the first sub-insulating pattern 120A may be perpendicular to an upper surface of the substrate 100.

The channel patterns CP may be disposed on the bit lines BL. The channel patterns CP may be spaced apart from each other in the second direction DR2 on each bit line BL. That is, the channel patterns CP may be spaced apart from each other in the first direction DR1 and the second direction DR2 crossing each other and disposed in a matrix form.

The channel patterns CP may be spaced apart from each other in the first direction DR1 in each of the channel trenches TRC. The first insulating pattern 120 may be disposed between the channel patterns CP adjacent to each other in the second direction DR2. The channel patterns CP may be disposed between the first insulating patterns 120 that are spaced apart from each other along the second direction DR2. The channel patterns CP may extend along the profile of the channel trench TRC.

According to the semiconductor device 20 according to the present embodiment, the dummy pattern AG may be disposed along the sidewall of the first sub-insulating pattern 120A of the first insulating pattern 120. The second sub-insulating pattern 120B may extend over the dummy pattern AG to cover the dummy pattern AG.

According to the present embodiment, the dummy pattern AG may extend in the first direction DR1 as in the direction in which the first insulating pattern 120 extends along the sidewall of the first sub-insulating pattern 120A of the first insulating pattern 120. The dummy pattern AG may contact the channel pattern CP in an area in which the channel pattern CP is disposed, and the dummy pattern AG may also be disposed in an area in which the channel pattern CP is not disposed.

The dummy pattern AG may be empty inside (i.e. the dummy pattern may comprise or be a cavity) so that air may be filled in the dummy pattern AG, oxygen (O₂) contained in the air may be diffused into the channel pattern CP contacting the dummy pattern AG, and oxygen may be injected into the channel pattern CP without the process of stacking and annealing an additional oxide layer.

Along the third direction DR3 perpendicular to the first and second directions DR1 and DR2, a height of the dummy pattern AG may be substantially the same as a height of the first sub-insulating pattern 120A of the first insulating pattern 120 and may be lower than a height of the channel pattern CP. However, the embodiment is not limited thereto, and along the third direction DR3, the height of the dummy pattern AG may be substantially the same as or higher than the height of the channel pattern CP.

According to the present embodiment, the dummy pattern AG may be disposed along the sidewalls of the first sub-insulating pattern 120A of the first insulating pattern 120, and may not be disposed on the sidewalls of the second sub-insulating pattern 120B of the first insulating pattern 120. Accordingly, the sidewalls of the second sub-insulating pattern 120B of the first insulating pattern 120 may support the channel pattern CP and the gate insulating pattern GL formed on the dummy pattern AG, and the shapes of the channel pattern CP and the gate insulating pattern GL may be prevented from being deformed by the air-filled dummy pattern AG.

The word lines WL1 and WL2 may extend lengthwise across the bit lines BL along the first direction DR1, and may be spaced apart from each other in the second direction DR2. The word lines WL1 and WL2 may be spaced apart from the bit line BL in the third direction DR3, and may cross the bit line BL. In a cross-sectional view, the channel patterns CP may have an approximately "U" shape with two vertically extending legs extending along a third direction DR3 perpendicular to the first direction DR1 and the second direction DR2. A pair of word lines WL1 and WL2 may be disposed between the two legs of the channel patterns CP in the channel trench TRC.

The gate insulating pattern GL may extend in the third direction DR3 along the word lines WL1 and WL2. The gate insulating pattern GL may not be disposed on a portion of the channel pattern CP that does not overlap the word lines WL1 and WL2 along the third direction DR3.

In a cross-sectional view parallel to the second direction DR2, the gate insulating pattern GL may extend along the side and lower surfaces of the word lines WL1 and WL2 adjacent to the channel pattern CP.

The second insulating pattern 130 may be disposed on the channel pattern CP and the lower insulating layer 110, and the second insulating pattern 130 may be disposed in the channel trench TRC. The second insulating pattern 130 may be disposed on the channel pattern CP and the word lines WL1 and WL2.

The second insulating pattern 130 may be disposed on a portion of the channel pattern CP that does not overlap the word lines WL1 and WL2 along the third direction DR3 to be in contact with the channel pattern CP.

The second insulating pattern 130 may extend along the side surfaces of the word lines WL1 and WL2 and along the upper surfaces of the word lines WL1 and WL2, and may be in contact with the side and upper surfaces of the word lines WL1 and WL2.

Similar to the gate insulating pattern GL, along the third direction DR3, a portion of the second insulating pattern 130 may protrude from the upper surfaces of the word lines WL1 and WL2, and may contact a portion of the protruding gate insulating pattern GL. For example, upper surfaces of the gate insulating pattern GL and the second insulating pattern 130 may be coplanar.

The third insulating pattern 140 may be disposed in the channel trench TRC. The third insulating pattern 140 may fill the channel trench TRC remaining after the channel pattern CP, the gate insulating pattern GL, the word lines WL1 and WL2, and the second insulating pattern 130 are formed.

The landing pads LP may be disposed on the first insulating pattern 120 and the third insulating pattern 140. The landing pads LP may be connected to the channel pattern CP. The landing pads LP may penetrate the interlayer insulating layer 150 to be in contact with the upper portion of the channel pattern CP. Each of the landing pads LP along the third direction DR3 may overlap at least a portion of the channel pattern CP. The landing pads LP may be spaced apart from each other in the first direction DR1 and the second direction DR2 and may be disposed in a matrix form. Side surfaces of the landing pads LP may contact side surfaces of the second sub-insulating pattern 120B.

The landing pad LP may be electrically connected to the channel pattern CP. For example, a lower surface of the landing pad LP may contact an upper surface of the channel pattern CP. However, the embodiment is not limited thereto, and as long as the landing pads LP are connected to the channel pattern CP, the disposition of the landing pads LP may be variously changed.

The interlayer insulating layer 150 may fill a space between the landing pads LPs spaced apart from each other in the second direction DR2 on the first insulating pattern 120 and the third insulating pattern 140. The interlayer insulating layer 150 may contact upper surfaces of the second sub-insulating pattern 120B and the third insulating pattern 140.

The data storage patterns DSP may be disposed on the landing pads LP, respectively. The data storage patterns DSP may be electrically connected to the channel pattern CP through the landing pads LP, respectively.

According to the semiconductor device 20 according to the present embodiment, the dummy pattern AG extending along the direction in which the first insulating pattern 120 extends is included on the sidewall of the first sub-insulating pattern 120A of the first insulating pattern 120, and the dummy pattern AG may be empty (i.e. the dummy pattern may comprise or be a cavity) so that air may be filled in the dummy pattern AG, and oxygen (O₂) contained in the air in the dummy pattern AG may diffuse into the channel pattern CP. Accordingly, oxygen may be injected into the channel pattern CP without a process of stacking and annealing an additional oxide layer.

As such, it is possible to increase the carrier concentration in the channel pattern CP without a process of stacking and annealing an additional oxide layer, thereby reducing manufacturing costs, preventing metal oxidation due to the annealing process, and providing a semiconductor device with excellent performance and operating characteristics and improved electrical characteristics.

Many features of the semiconductor device 10 according to the previously described embodiment are all applicable to the semiconductor device 20 according to the present embodiment.

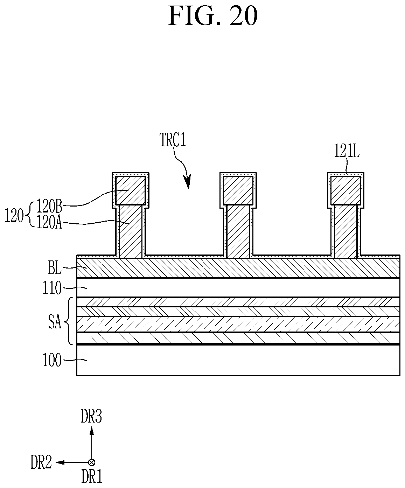

A method for manufacturing the semiconductor device 20 according to the embodiment will be described with reference to FIG. 20 to FIG. 30 together with FIG. 17 to FIG. 19. FIG. 20 to FIG. 30 illustrate cross-sectional views of a method for manufacturing a semiconductor device according to another embodiment. FIG. 20 to FIG. 30 illustrate cross-sectional views taken along line A-A' of FIG. 17.

Referring to FIG. 20, on the bit lines BL and the lower insulating layer 110, the first trenches TRC1 extending in the first direction DR1 and spaced apart from each other in the second direction DR2 may be defined, and the first insulating pattern 120 including the first sub-insulating pattern 120A and the second sub-insulating pattern 120B disposed on the first sub-insulating pattern 120A may be formed, and the sacrificial layer 121L may be conformally deposited on the upper surface and the side surface of the first insulating pattern 120 and the upper surface of the bit line BL.

The width of the second sub-insulating pattern 120B of the first insulating pattern 120 may be wider than the width of the first sub-insulating pattern 120A thereof.

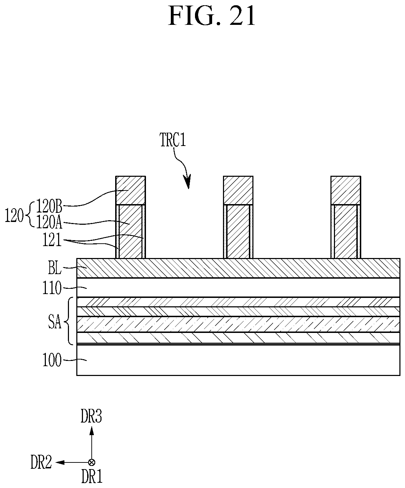

Referring to FIG. 21, the sacrificial layer 121L may be etched to remove the sacrificial layer 121L disposed on the upper surface and the side surface of the second sub-insulating pattern 120B of the first insulating pattern 120 and the upper surface of the bit line BL, having a relatively wide width, thereby forming the sacrificial pattern 121 disposed along the sidewall of the first sub-insulating pattern 120A of the first insulating pattern 120. For example, the sacrificial layer 121L disposed on the upper surface and the side surface of the second sub-insulating pattern 120B of the first insulating pattern 120 and the upper surface of the bit line BL may be removed through an anisotropic etching process, but the embodiment is not limited thereto.

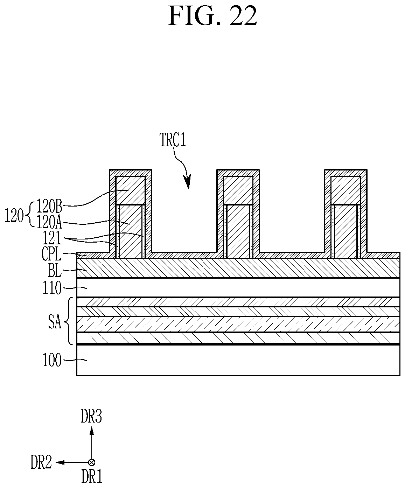

Referring to FIG. 22, the channel pattern material layer CPL may be conformally deposited on the upper surfaces of the first insulating pattern 120 and the sacrificial pattern 121, the side surface of the sacrificial pattern 121, and the upper surface of the bit line BL.

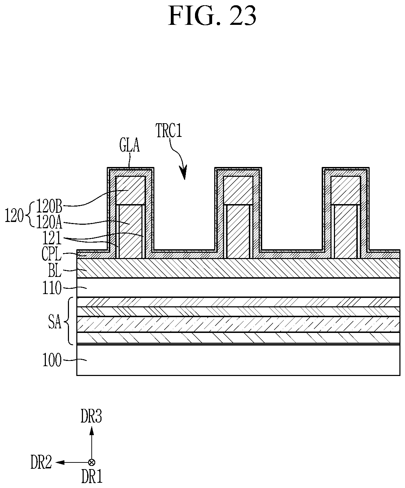

Referring to FIG. 23, the first gate insulating layer GLA may be stacked on the channel pattern material layer CPL, and by patterning the first gate insulating layer GLA and the channel pattern material layer CPL, the first gate insulating layer GLA and the channel pattern material layer CPL may be left only in the area in which the channel pattern CP is disposed in a plan view. In this case, the first gate insulating layer GLA and the channel pattern material layer CPL disposed in the area in which the channel pattern CP is not disposed may be removed.

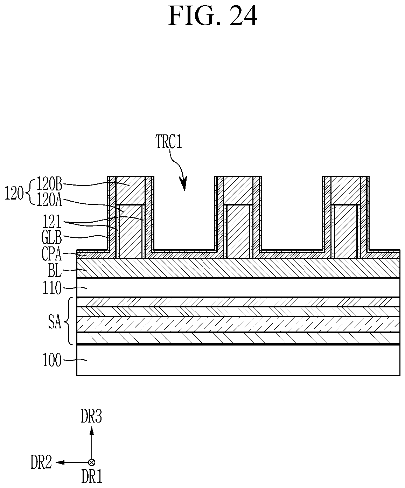

Referring to FIG. 24, the first gate insulating layer GLA and the channel pattern material layer CPL disposed on the first insulating pattern 120 may be removed to form the preliminary channel pattern CPA disposed on the side surface of the first insulating pattern 120 and the upper surface of the bit line BL in the first trench TRC1, the first preliminary gate insulating pattern GLB disposed on the preliminary channel pattern CPA may be formed, and the upper surface of the first insulating pattern 120 may be exposed.

The preliminary channel pattern CPA is formed along the profile of the first trench TRC1, and the upper surface of the preliminary channel pattern CPA may be disposed at substantially the same level as the upper surface of the first insulating pattern 120.

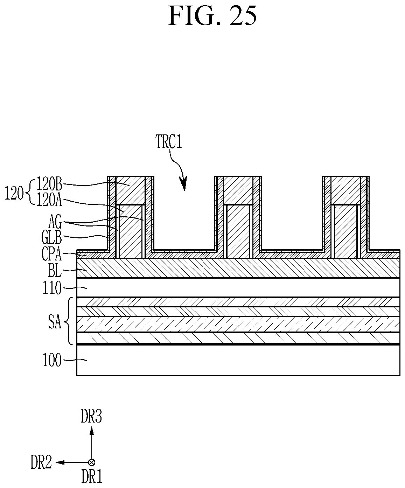

Referring to FIG. 25, the sacrificial pattern 121 disposed along the sidewall of the first sub-insulating pattern 120A of the first insulating pattern 120 may be removed to form the air-filled dummy pattern AG.

The sacrificial pattern 121 may be removed by a wet etching process, but the embodiment is not limited thereto.

According to the present embodiment, the dummy pattern AG may be formed to be disposed along the sidewalls of the first sub-insulating pattern 120A of the first insulating pattern 120, and may be formed not to be disposed on the sidewalls of the second sub-insulating pattern 120B of the first insulating pattern 120. Accordingly, the sidewalls of the second sub-insulating pattern 120B of the first insulating pattern 120 may support the channel pattern CP and the gate insulating pattern GL formed on the dummy pattern AG, and the shapes of the channel pattern CP and the gate insulating pattern GL may be prevented from being deformed by the air-filled dummy pattern AG.

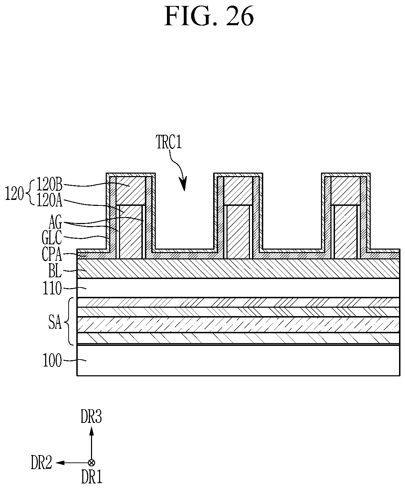

Referring to FIG. 26, a gate insulating pattern material may be conformally deposited on the upper surface of the first insulating pattern 120 and the upper surface of the preliminary channel pattern CPA and on the first preliminary gate insulating pattern GLB to form a second preliminary gate insulating pattern GLC.

The second preliminary gate insulating pattern GLC may also be formed in an area of the first trench TRC1 in which the channel pattern CP will not be formed.

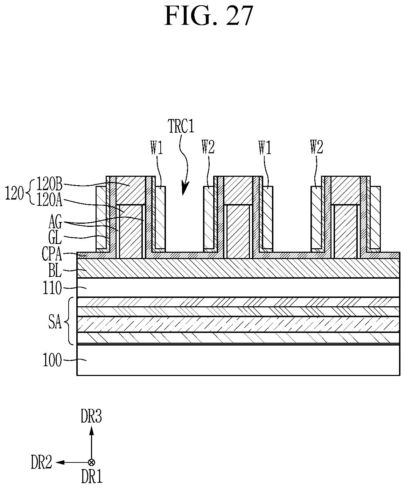

Referring to FIG. 27, the gate insulating pattern GL and the word lines WL1 and WL2 may be formed in the first trench TRC1 by stacking a word line material layer on the second preliminary gate insulating pattern GLC and etching the second preliminary gate insulating pattern GLC and the word line material layer.

By performing an anisotropic etching process on the word line material layer WLA, a pair of word lines WL1 and WL2 that are separated to be spaced apart from each other along the second direction DR2 may be formed in the first trench TRC1. In addition, the gate insulating patterns GL that are separated to be spaced apart from each other along the second direction DR2 may be formed in the first trench TRC1.

During the anisotropic etching process for the word line material layer WLA, the upper surfaces of the word lines WL1 and WL2 may be lower than the upper surface of the second channel pattern CP2. Alternatively, in another embodiment, an etching process of recessing the upper surfaces of the word lines WL1 and WL2 may be additionally performed.

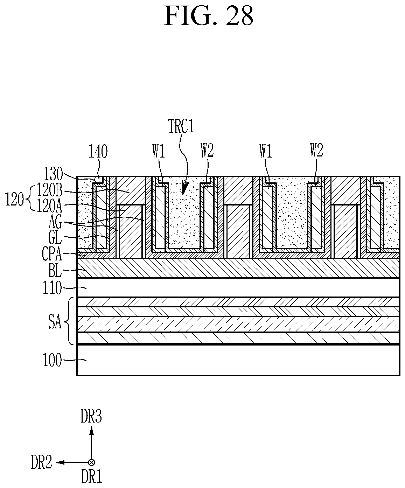

Referring to FIG. 28, the second insulating pattern 130 and the third insulating pattern 140 may be formed on the gate insulating pattern GL and the word lines WL1 and WL2. The third insulating pattern 140 may fill the first trench TRC1.

The second insulating pattern 130 may be conformally formed along the profiles of the gate insulating pattern GL, the word lines WL1 and WL2, and the preliminary channel pattern CPA in the first trench TRC1, and the third insulating pattern 140 may be formed to fill the first trench TRC1 remaining after the second insulating pattern 130 is formed.

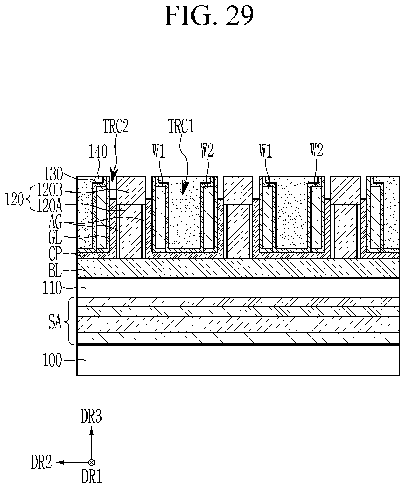

Referring to FIG. 29, the channel pattern CP may be formed and the second trench TRC2 may be formed through an etching process of recessing a portion of the preliminary channel pattern CPA.

Specifically, the preliminary channel pattern CPA may be partially wet-etched from the upper surface thereof toward the lower surface thereof to form the channel pattern CP and form the second trench TRC2 extending in the third direction DR3. Accordingly, the upper surface of the channel pattern CP may be disposed at a lower level than the upper surfaces of the word lines WL1 and WL2.

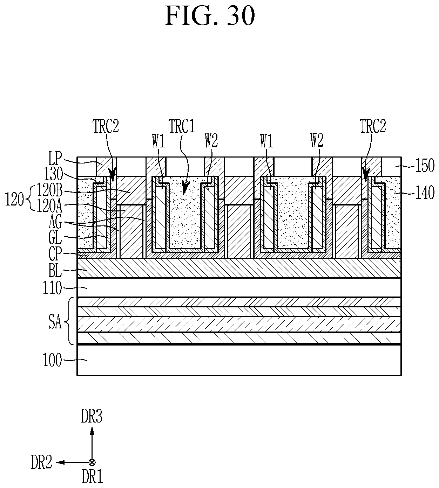

Referring to FIG. 30, the landing pads LP filling the second trench TRC2 and connected to the channel pattern CP may be formed and the interlayer insulating layer 150 filling a space between the landing pads LP may be formed.

Specifically, after patterning the landing pads LP to form holes exposing the upper surfaces of the first and third insulating patterns 120 and 140, the interlayer insulating layer 150 may be embedded in the holes, and then a planarization process may be performed.

Specifically, after patterning the landing pads LP to form holes exposing the upper surfaces of the first and third insulating patterns 120 and 140, the interlayer insulating layer 150 may be embedded in the holes, and then a planarization process may be performed. For example, the interlayer insulating layer 150 may fill the holes between the landing pads LP.

The data storage patterns DSP may be formed on the landing pads LP, respectively, to form the semiconductor device 20 according to an embodiment. In the embodiment, when the data storage patterns DSP include capacitors, lower electrodes, capacitor dielectric layers, and upper electrodes may be sequentially formed.

According to the method for manufacturing the semiconductor device according to the present embodiment, by forming the sacrificial layer on the sidewall of the first insulating pattern 120, forming the channel pattern, and then removing the sacrificial layer to form the dummy pattern filled with air in the area of the sacrificial layer, oxygen contained in the dummy pattern may be diffused into the channel pattern without an additional annealing process. Accordingly, the manufacturing method is simplified, which may reduce the manufacturing cost, metal oxidation due to the annealing process may not occur, and a semiconductor device with excellent performance and operation characteristics and improved electrical characteristics may be provided.

Many features of the method for manufacturing the semiconductor device 10 according to the embodiment described above with reference to FIG. 4 to FIG. 16 are all applicable to the method for manufacturing the semiconductor device 20 according to the present embodiment.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

### <Description of Symbols>

100: substrate
110: lower insulating layer
120: first insulating pattern
130: second insulating pattern
140: third insulating pattern
150: interlayer insulating layer
PS: peripheral circuit structure
CS: cell array structure
SA: peripheral circuits
BL: bit line
GL: gate insulating pattern
CP: channel pattern
AG: dummy pattern
WL: word line
LP: landing pad
DSP: data storage pattern

## Claims

1. A semiconductor device comprising:
a substrate (100);
a bit line (BL) disposed on the substrate (100);
an insulating pattern (120) disposed on the bit line (BL);
a channel pattern (CP) disposed on the bit line (BL) and extending in a vertical direction (DR3) substantially perpendicular to a surface of the substrate (100) along an upper surface of the bit line (BL) and a sidewall of the insulating pattern (120);
a dummy pattern (AG) disposed between the insulating pattern (120) and the channel pattern (CP);
a word line (WL1, WL2) that intersects the bit line (BL) and is spaced apart from the channel pattern (CP);
a gate insulating pattern (GL) disposed between the channel pattern (CP) and the word line (WL1, WL2); and
a landing pad (LP) connected to the channel pattern (CP).

2. The semiconductor device of claim 1, wherein the dummy pattern (AG) includes air.

3. The semiconductor device of claim 2, wherein the dummy pattern (AG) includes a space from which a sacrificial layer is removed.

4. The semiconductor device of any one of claims 1 to 3, wherein in a plan view of the substrate (100) from above:
the insulating pattern (120) extends along a first direction (DR1), and
the dummy pattern (AG) includes a plurality of dummy patterns (AG) spaced apart from each other along the first direction (DR1).

5. The semiconductor device of claim 4, wherein the dummy patterns (AG) are disposed on two sidewalls of the insulating pattern (120) facing each other along a second direction (DR2) substantially perpendicular to the first direction (DR1).

6. The semiconductor device of claim 4 or 5, wherein along the vertical direction (DR3), a height of the dummy pattern (AG) is substantially the same as a height of the channel pattern (CP).

7. The semiconductor device of any one of claims 4 to 6, wherein along the first direction (DR1), a width of the dummy pattern (AG) is substantially the same as a width of the channel pattern (CP).

8. The semiconductor device of claim 2, wherein in a plan view of the substrate (100) from above, the insulating pattern (120) and the dummy pattern (AG) extend along a first direction (DR1).

9. The semiconductor device of claim 8,
wherein the insulating pattern (120) includes a first sub-insulating pattern (120A) and a second sub-insulating pattern (120B) disposed on the first sub-insulating pattern (120A), and
wherein the dummy pattern (AG) is disposed on a sidewall of the first sub-insulating pattern (120A).

10. The semiconductor device of claim 9, wherein along a second direction (DR2) substantially perpendicular to the first direction (DR1), a width of the second sub-insulating pattern (120B) is greater than a width of the first sub-insulating pattern (120A).

11. The semiconductor device of claim 9 or 10, wherein along the vertical direction (DR3), a height of the dummy pattern (AG) is less than that of the channel pattern (CP).

12. The semiconductor device of any one of claims 9 to 11, wherein at least a portion of a sidewall of the second sub-insulating pattern (120B) is in contact with the channel pattern (CP).

13. A method for manufacturing a semiconductor device, comprising:
forming a bit line (BL) on a substrate (100);
forming an insulating pattern (120) on the bit line (BL);
forming a sacrificial layer (121) on a sidewall of the insulating pattern (120);
forming a channel pattern (CP) extending in a vertical direction (DR3) substantially perpendicular to a surface of the substrate (100) along an upper surface of the bit line (BL) and a sidewall of the insulating pattern (120) on the bit line (BL);
removing the sacrificial layer (121) to form a dummy pattern (AG) disposed between the insulating pattern (120) and the channel pattern (CP);
forming a word line (WL1, WL2) that intersects the bit line (BL) and is spaced apart from the channel pattern (CP);
forming a gate insulating pattern (GL) disposed between the channel pattern (CP) and the word line (WL1, WL2); and
forming a landing pad (LP) connected to the channel pattern (CP).

14. The method for manufacturing the semiconductor device of claim 13, wherein the dummy pattern (AG) includes air.

15. The method for manufacturing the semiconductor device of claim 14, wherein in a plan view of the substrate (100) from above:
the insulating pattern (120) extends along a first direction (DR1),
the dummy pattern (AG) includes a plurality of dummy patterns (AG) spaced apart from each other along the first direction (DR1),
along the vertical direction (DR3), a height of the dummy pattern (AG) is substantially the same as a height of the channel pattern (CP), and
along the first direction (DR1), a width of the dummy pattern (AG) is substantially the same as a width of the channel pattern (CP).
